# EUROPEAN PATENT SPECIFICATION

(11) **EP 4 167 259 B1**
(45) Date of publication and mention of the grant of the patent: **15.04.2026**
(21) Application number: 21202236.2
(22) Date of filing: 12.10.2021
(51) Int. Cl.: F16B 21/07, H01G 2/04, H05K 5/00, H05K 7/12, H05K 3/30, F16B 9/02, H05K 1/00, H01G 9/08, H01G 9/06, H01G 2/10, H01G 2/06

(54) **MOUNTING STRUCTURE FOR A CAPACITOR**
MONTAGESTRUKTUR FÜR EINEN KONDENSATOR
STRUCTURE DE MONTAGE POUR UN CONDENSATEUR

(43) Date of publication of application: 19.04.2023
(73) Proprietor: Veoneer Sweden Safety Systems AB, 10302 Stockholm (SE)
(72) Inventor: SAVIN, Anatolie, 700051 Iasi (RO); CACU, Adrian, 700051 Iasi (RO)
(74) Representative: Reichert & Lindner Partnerschaft Patentanwälte

(56) References cited:
- CN-U- 208 507 463
- CN-U- 211 828 480
- FR-A1- 2 885 671
- JP-A- 2005 123 307
- US-A1- 2009 257 199
- US-A1- 2018 242 460
- US-A1- 2021 305 726

## Description

### FIELD OF THE INVENTION

The invention relates to a mounting structure for a capacitor. The mounting structure has a first pair and a second pair of holding elements, which are integral parts of the mounting structure.

### DESCRIPTION OF THE BACKGROUND ART

EP 3 240 375 A1 relates to an electronic module for an actuator that can be used in a motor vehicle. The printed circuit board of the electronic module carries at least one cylindrical capacitor and is spaced apart by means of a holding element. The holding element has elastic biased holder cams. The elastic holder cams hold the cylindrical capacitor in a force-fit manner.

DE 10 2012 002 525 A1 discloses a housing structure for a capacitor. The housing structure has a housing base that is provided with a fastening bolt for fastening a housing portion in a slot or for inserting a holder or a plate in an elongated recess. A dimension-side complementary web is extended from the housing base by a surface of the fastening bolt to fix the housing portion in a precise position and to secure against rotation. The fastening bolt is provided with a partially circumferential cantilever portion.

CN 207818380 U discloses an electrolytic capacitor mount.

CN 210575548 U discloses a capacitor installation structure comprising a fixed frame which is an insulator. The fixed frame is fixed on a circuit board. The fixing frame is rectangular, and the shape of the fixing frame is matched with the shape of the capacitor. The capacitor is clamped in the fixed frame. Clamping devices for fixing the capacitor are symmetrically arranged on the inner wall of the fixing frame. The clamping devices are insulators, and each clamping device comprises an elastic component.

US 2018 / 0 242 460 A1 discloses a cradle-type mounting structure for a capacitor. Two pairs of arms receive the capacitor between them.

CN 211828480 U discloses fixing a capacitor to a base plate by means of a brace having two arms connectable by a strap. The strap has plural holes which cooperate with a pin to adapt to a diameter of the capacitor.

CN 208507463 U discloses a mounting clip for a capacitor. The clip can receive a capacitor and be fixed to some assembly where the capacitor is required. The clip has two semicircular portions which can be connected by an elastic element.

JP 2005 123307 A discloses a fixing strap for a capacitor.

FR 2 885 671 A1 discloses a collar for securing tubes or cables of various diameters. The collar has two arms. The arms can be locked together by a notched articulated portion attached to one end of an arm, which articulated portion is to engage a notched section at the end of the other arm. The adaptation to various diameters is accomplished by a deformable strap.

US 2009 / 0 257 199 A1 shows a cradle-type mounting structure for a capacitor, including an additional fixing means close to where the electric contacts of a mounted capacitor are.

As known, an electrical control unit (ECU) is an embedded electronic device. A typical ECU consists of a printed circuit board (PCB), a housing, a cover and, in some cases, a backup power unit. It must be ensured that the ECU is supplied with power even in cases where the main power unit has a malfunction. For this reason, the backup power unit is provided, which often is a relatively heavy capacitor. In the case of plastic housings, the fixation of the backup power unit is realized via a mounting structure, also called "cradle", with a plastic snap-fit solution. The mounting structure is integrated in the plastic housing.

To keep the capacitor in place with prior art devices, the mounting structure (cradle) simply relies on the interference between the holding elements (plastic snaps) and the capacitor, which means that the holding elements will be loaded with an elastic force to provide the necessary retention force.

In theory, the prior art concept works sufficiently well. But, in reality, when considering all the tolerances of the diameter of the capacitor, the interference can transform into a gap which may lose capacitor or cause a rattle noise. In case the diameter of the capacitor is too big, the interference may translate in over-stressed holding elements (snaps) which may cause plastic or permanent deformations, creep, fractures etc. of the holding elements. The biggest tolerance that makes the task of keeping the interference within a reasonable interval is the capacitor tolerance.

### SUMMARY OF THE INVENTION

It is an object of the present invention to provide a mounting structure which can easily and efficiently accommodate even large tolerances of the capacitor diameter and the distance between the holding elements.

The above object is achieved by a mounting structure for a capacitor according to the features of claim 1.

The invention is defined by the appended claims.

According to an embodiment, the mounting structure for a capacitor has a first pair and a second pair of holding elements, which are integral parts of the mounting structure. The second pair of holding elements is defined by a first arm and a second arm, each of which having an inner circular arc surface with a curvature. The curvature of the first arm and the second arm is the same as the curvature of a surface of the capacitor. A nose is formed at a free end of the first arm. The nose cooperates with at least one recess, formed at a free end of the second arm. As a consequence, the inner circular arc surface of the first arm and the second arm abut on the surface of the capacitor.

The locking mechanism is due to the angles on the nose and the at the least one recess, provided on the first arm and the second arm, which make the capacitor pull-out force very high.

The advantage of the present invention is that regardless of variations in diameter of the capacitor, a secure and durable fixation of the capacitor in the mounting structure can be secured.

According to an embodiment, the mounting structure is injection-molded. The first arm and the second arm of the second pair of holding elements are connected via a leg to a bottom of the mounting structure (cradle). The mounting structure can be formed as a separate device. Furthermore, the mounting structure may be formed as an integral part of a housing part both of which are injection-molded.

The first arm and the second arm of the second pair of holding elements may be molded such that the first arm and the second arm form an open position which allows insertion of the capacitor. In an embodiment, once the capacitor is inserted in the mounting structure, the nose of the first arm is inserted in the recess close to the free end of the second arm. Consequently, the inner circular arc surfaces of the first arm and the second arm abut on the surface of the capacitor in a form and force fitting manner. Here the tolerance situation is shown where the capacitor has a diameter of the maximum allowable tolerance.

According to another tolerance situation of the capacitor used, the nose of the first arm may be inserted into the recess further away from the free end of the second arm. As a result, the inner circular arc surfaces of the first arm and the second arm abut on the surface of the capacitor in a form and force fitting manner. The capacitor has a diameter of the minimum allowable tolerance.

The advantage of current invention of the mounting structure (cradle) with a ratchet mechanism (cooperation of nose and recess) provides a solution that can easily and efficiently accommodate the big tolerances not only of the capacitor diameter but also of the holding elements opening. The inventive mounting structure provides similar performance of the mounting structure (cradle) from the minimum worst case (capacitor on minimum tolerance and opening of holding elements on maximum tolerance) to the maximum worst case (capacitor on maximum tolerance and holding elements on minimum tolerance).

In an embodiment, an electronic control unit for a vehicle is provided, wherein the electronic control unit incorporates a mounting structure as described above.

The invention relies on the removal of one pair of holding elements (left-right) and their replacement with holding elements which are based on a ratchet mechanism, similar to a zip-tie. If considered necessary, the pitch of the recesses can be decreased and the number of the engagement levels (number of recesses) will be increased. However, considering the tolerances and the fact that inventive mounting structure still benefits from the elastic properties of the plastic material of the mounting structure, two recesses (engagement levels between nose and recess) should be sufficient.

### BRIEF DESCRIPTION OF THE DRAWINGS

The numerous advantages of the disclosure may be better understood by those skilled in the art by reference to the accompanying figures in which:
Figure 1 shows a schematic representation of the placement of an electronic control unit (ECU) in a vehicle.
Figure 2 is a perspective view of an embodiment of a prior art capacitor cradle (for example, being an integral part of a plastic housing).
Figure 3 is a perspective, sectional view along line A-A of Fig. 2, wherein a capacitor is placed in the prior art cradle.
Figure 4 is a front, sectional view along line A-A of Fig. 2, wherein a capacitor with a minimum allowed diameter tolerance is placed in the prior art cradle.
Figure 5 is a front, sectional view along line A-A of Fig. 2, wherein a capacitor with a maximum allowed diameter tolerance is placed in the prior art cradle.
Figure 6 shows a cradle design for discussing the pull-out force of capacitors having different diameters.
Figure 7 shows mounting structures for discussing the resulting snap force of holding elements of a mounting structure (cradle) in a Y-direction, wherein the capacitors have different diameters.
Figure 8 is a perspective view of an embodiment of the mounting structure (cradle) according to the present invention.
Figure 9 is a cut-view along line B-B of the mounting structure (cradle) as shown in Fig. 8.
Figure 10 is a front view of the cradle as shown in Fig. 8, with a capacitor fixed in place.
Figure 11 is a perspective front view of the cradle as shown in Fig. 8, with a capacitor fixed in place, wherein the capacitor has the maximum allowed diameter.
Figure 12 is a perspective front view of the cradle as shown in Fig. 8, with a capacitor fixed in place, wherein the capacitor has the minimum allowed diameter.

### DETAILED DESCRIPTION

In the ensuing description, numerous specific details are provided to enable maximum understanding of the embodiments that are provided by way of example. The embodiments may be implemented with or without specific details, or else with other methods, components, materials, etc. In other circumstances, well-known structures, materials, or operations are not illustrated or described in detail so that various aspects of the embodiments will not be obscured. Reference in the course of the present description to "an embodiment" or "one embodiment" means that a particular structure, peculiarity, or characteristic described in connection with its implementation is comprised in at least one embodiment. Hence, phrases such as "in an embodiment" or "in one embodiment" that may recur in various points of the present description do not necessarily refer to one and the same embodiment.

Furthermore, the particular structures, peculiarities, or characteristics may be combined in any convenient way in one or more embodiments.

Same reference numerals refer to same elements or elements of similar function throughout the various figures. Furthermore, only reference numerals necessary for the description of the respective figure are shown in the figures. The shown embodiments represent only examples of how the invention can be carried out. This should not be regarded as a limitation of the invention.

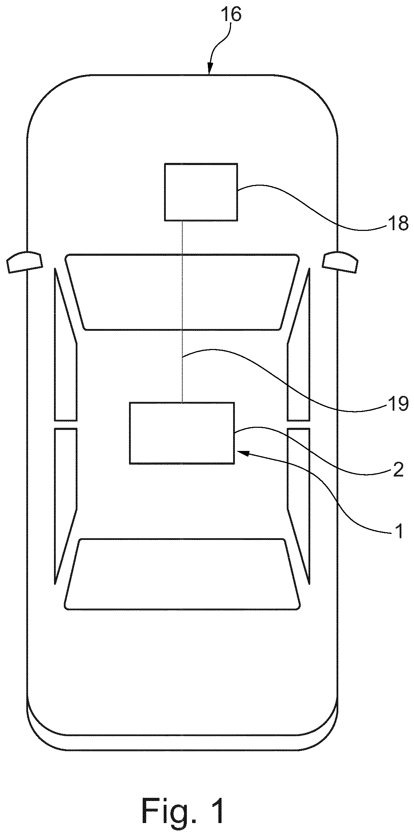

**Figure 1** shows a schematic representation of an embodiment of a placement of an electronic control unit (ECU) **1** for a vehicle **16.** Electronic control unit **1** controls one or more electrical systems of vehicle **16** and is enclosed by a housing **2.** Housing **2** may be made of plastics or metallic materials. In cases where vibrations are more extreme during use of vehicle **16,** housing **2** may be made of metallic materials, such as die-cast aluminium. To supply electrical power to ECU **1,** ECU **1** is electrically connected to a vehicle battery **18** (main battery), typically by an electric line **19.**

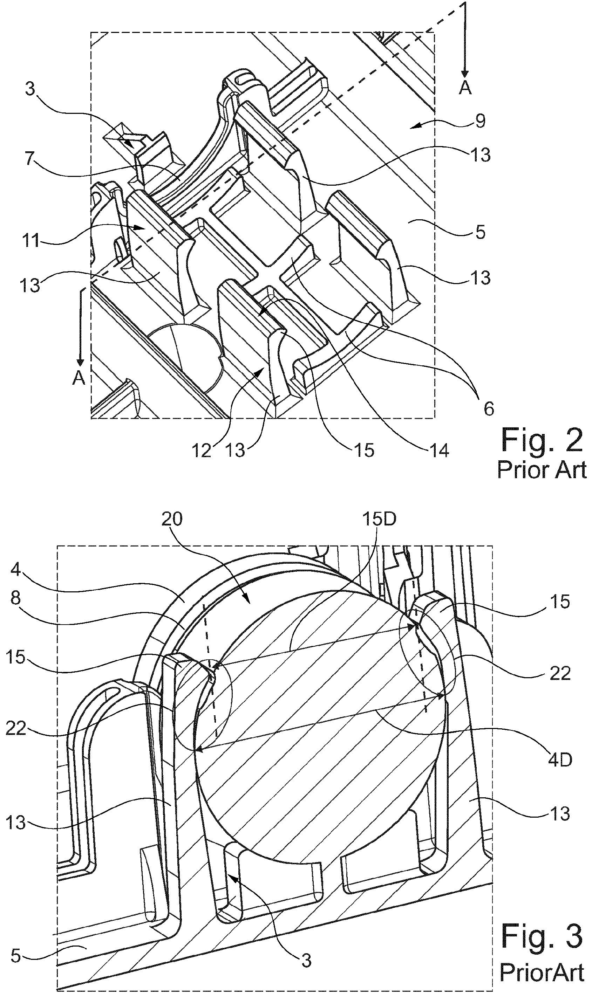

**Figure 2** shows a perspective view of an embodiment of a prior art mounting structure **3** (cradle) for a capacitor **4** (see Fig. 3). In the embodiment shown here, the mounting structure **3** is an integral part of a housing part **9.** The mounting structure **3** has several support surfaces **6,** which are provided on a bottom **5** of housing part **9.** An alignment support **7** is as well an integral part of the mounting structure **3.** Once the capacitor **4** is positioned in the mounting structure **3,** the alignment support **7** is in a form fitting contact with a circumferential notch **8** (see Fig. 3) of capacitor **4.** Circumferential notch **8** enables a correct positioning of capacitor **4** in the mounting structure **3.**

At least a first pair **11** and a second pair **12** of holding elements **13** extend upright from the bottom **5** of mounting structure **3** or the bottom of housing part **9.** A nose **15** is provided at a free end **14** of each holding element **13.** The noses **15** of the first pair **11** of holding elements **13** and the noses **15** of the second pair **12** of holding elements **13** face each other. The holding elements **13** are elastic and keep the capacitor **4** in place. The kind of mounting structure **3,** shown here, simply relies on the interference between the holding elements **13** (e.g., plastic snaps) and the capacitor **4,** which means that the holding mounting structure elements **13,** loaded with an elastic force by the insertion of capacitor **4** into cradle **3,** provide a necessary retention force for capacitor **4.**

**Figure 3** is a perspective, sectional view along line A-A of Fig. 2, wherein capacitor **4** is placed in prior art mounting structure **3.** Here, only the noses **15** of the two opposing holding elements **13** of the first pair **11** of holding elements **13** are shown. The noses **15** of the two opposing holding elements **13** are spaced apart at a distance **15D,** even with the inserted capacitor **4,** which has a diameter smaller than diameter **4D** of capacitor **4.** During the insertion of capacitor **4** into mounting structure **3,** the two opposing holding elements **13** are pushed apart, and once capacitor **4** is in its final position, as shown here, the opposing holding elements **13** exert a retention force on a surface **20** of capacitor **4.** Accordingly, a portion of each holding element **13** abuts against the surface **20** of capacitor **4,** in particular, against surface **20** in the marked areas **22** in Fig. 3.

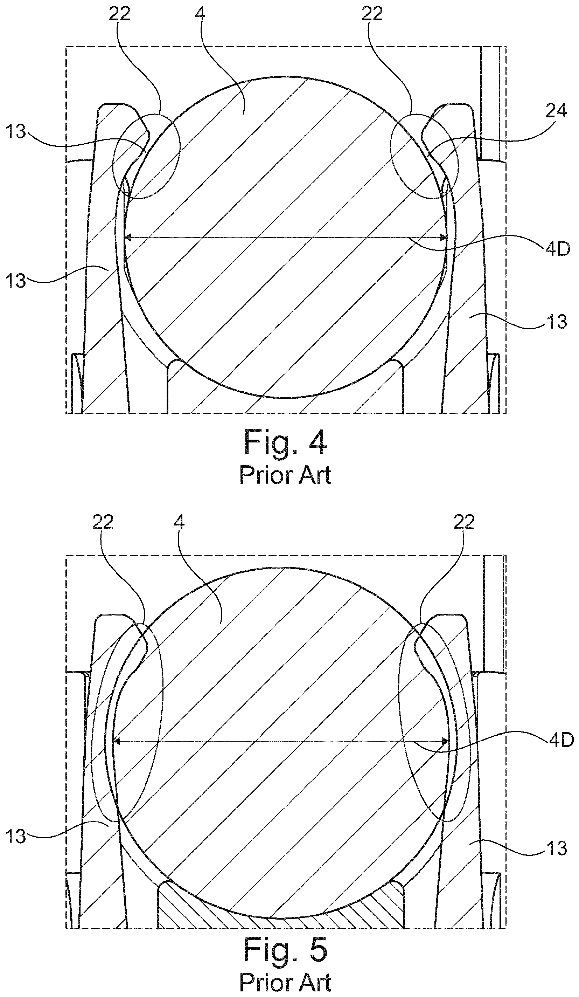

In theory, the above concept works great. But in reality, when considering the tolerances of diameter **4D** of capacitor **4,** the abutment of each holding element **13** can transform into a gap **24** as shown in **Figure 4** (see marked areas **22** in Fig. 4). Here, the diameter **4D** of capacitor **4** is at a minimum, and consequently the capacitor **4** can become loose, cause a rattling noise, or the like.

**Figure 5** shows the situation in which the diameter **4D** of capacitor **4** is at a maximum. Consequently, the interference or the abutment of the opposing holding elements **13** translate in over-stressed holding elements **13,** plastic (permanent) deformations, creep, fractures, or the like, of holding elements **13.** The areas with over-stress between capacitor **4** and holding elements **13** are the marked areas **22** in Fig. 5. In contrary to Fig. 4, no gap **24** is formed.

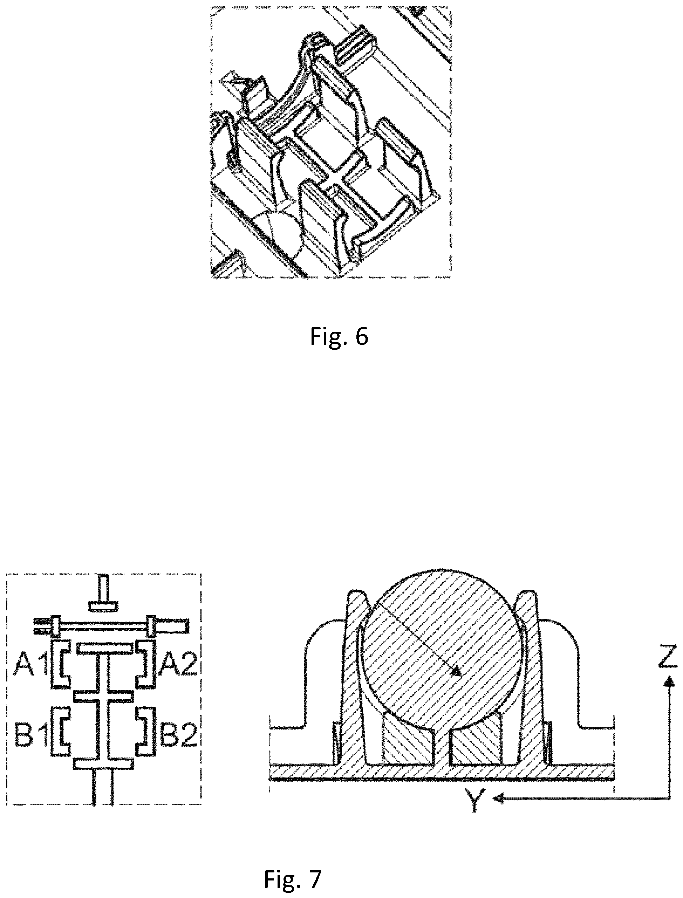

**Figure 6** shows a cradle design. For the pull-out force of a capacitor **4** from the prior art mounting structure **3** design (cradle design) as shown, the following applies: The considered mounting structure **3** has the minimum distance **15D** of 14.8 mm between the noses **15** of the first pair **11** and second pair **12** of opposing holding elements **13.** For the determination of the pull-out force for capacitor **4,** the two worst cases of the diameter 4D of capacitor **4** were considered (minimum diameter = 17.5 mm and maximum diameter = 18.5 mm). The pull-out force for the diameter 17.5 mm is 55.8 N, for the capacitor diameter 18.5 mm it is 104 N. The capacitor **4** pull-out force is almost half for the capacitor **4** minimum diameter **4D** compared with the capacitor **4** with the maximum diameter **4D.**

**Figure 7** shows mounting structures for discussion of the resulting snap force of holding elements **13** (snaps) of a mounting structure (cradle) **3** in a Y-direction, wherein the capacitors **4** have different diameters **4D.** The normal force (snap force) between the opposing holding elements **13** (snaps) and the capacitor **4** is considerable for the capacitor **4** with maximum diameter **4D,** equal to 18.5 mm. The normal force between the opposing holding elements **13** A1 and A2 results in 14.9N and between the opposing holding elements **13** B1 and B2 results in 17N. For the capacitor **4** with the minimum diameter **4D,** equal to 17.5 mm, the normal force between the opposing holding elements **13** A1 and A2 results in 1.64N and between the opposing holding elements **13** B1 and B2 results in 1.63N. The low forces which exist if a capacitor **4** with the minimum diameter **4D** is mounted in the mounting structure **3** (cradle) will cause the capacitor **4** to rattle at low frequency and thus causing the module to resonate.

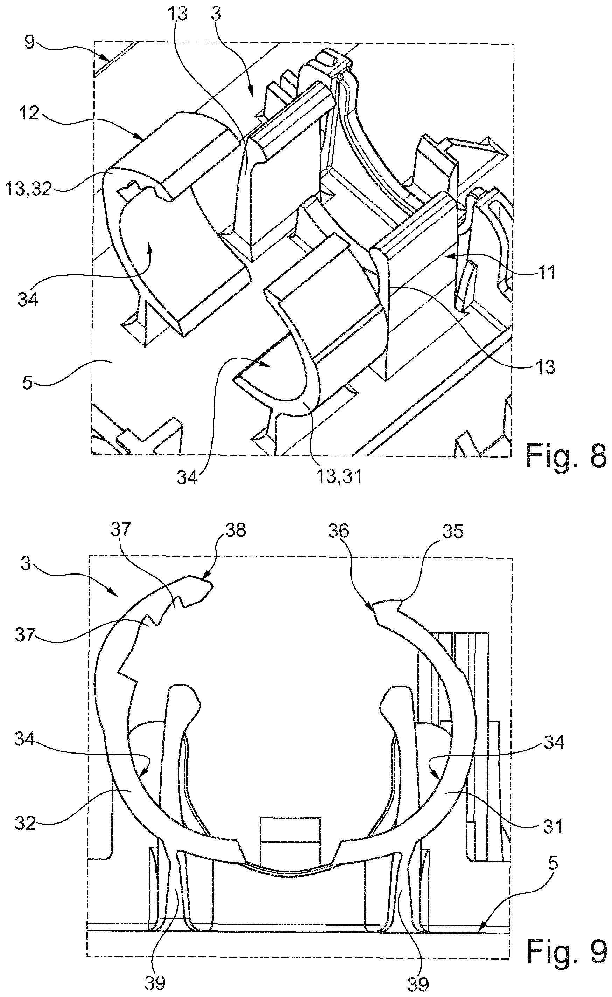

**Figure 8** is a perspective view of an embodiment of the mounting structure **3** (cradle) according to the present invention. The embodiment of mounting structure **3** shown here has as well a first pair **11** and a second pair **12** of holding elements **13,** which are integral parts of mounting structure **3.** Housing part **9** is made of an injection-moldable material, and consequently, the injection-molded mounting structure **3** is an integral part of housing part **9.**

In the embodiment shown here, the second pair **12** of holding elements **13** is defined by a first arm **31** and a second arm **32.** The first arm **31** and the second arm **32** define an inner circular arc surface **34** which has a curvature that is the same as the curvature of a surface **20** of capacitor **4.** As mentioned above, mounting structure **3** is injection-molded. Furthermore, the first arm **31** and the second arm **32** of second pair **12** of holding elements **13** are connected via an elastic leg **39** (see Fig. 9) to the bottom **5** of housing part **9.**

**Figure 9** is a cut-view along line B-B of the mounting structure **3** (cradle) as shown in Fig. 8. Fig. 9 shows that the first arm **31** and the second arm **32** of second pair **12** of holding elements **13** are molded such that the first arm **31** and the second arm **32** form an open position which allows insertion of capacitor **4** into mounting structure **3.** When the first arm **31** and the second arm **32** are joined together to fix the capacitor **4** in position, the first arm **31** and the second arm **32** cooperate in a ratchet like manner.

First arm **31** has a nose **35** at its free end **36** to allow the capacitor **4** to be mounted. Accordingly, second arm **32** has at least one recess **37** close to its free end **38.** In the embodiment shown here, two recesses **37** are provided at the second arm. For a person skilled in the art it is obvious that the invention is not limited to this specific embodiment of nose **35** and at least one recess **37.**

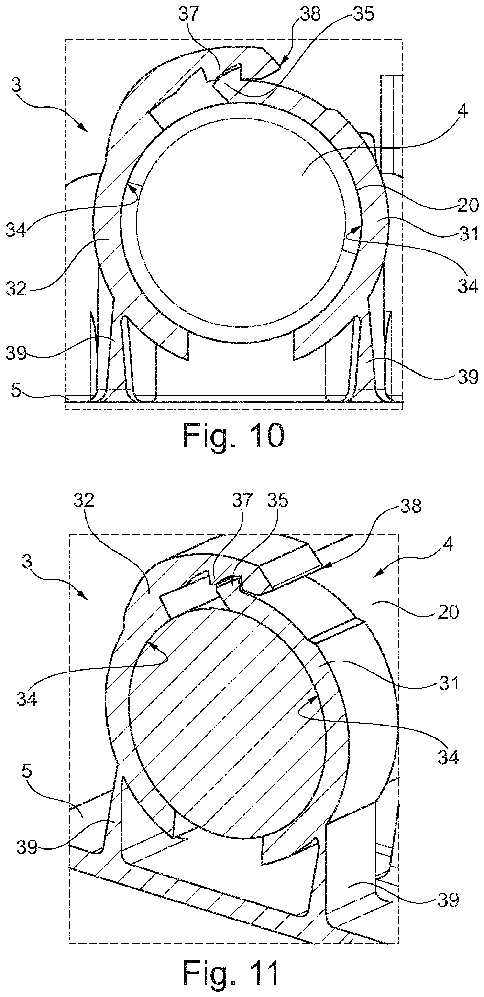

**Figure 10** is a front view of the mounting structure **3** (cradle) as shown in Fig. 8, with a capacitor **4** fixed in place. When capacitor **4** is in the mounted position, the inner circular arc surface **34** of first arm **31** and the inner circular arc surface **34** of second arm **32** abut on surface **20** of capacitor **4.** To maintain the force of first arm **31** and second arm **32** acting onto capacitor **4,** the nose **35** of first arm **31** is inserted into one of the at least one recesses **37** of second arm **32** which recess **37** is close to the free end **38** of second arm **32.**

**Figure 11** is a perspective front view of the mounting structure **3** (cradle) as shown in Fig. 8, with a capacitor **4** fixed in place, wherein the capacitor **4** has the maximum allowed diameter **4D.** With this diameter condition, nose **35** of first arm **31** is inserted into the respective recess **37** of second arm **32,** which is close to the free end **38** of second arm **32.** The inner circular arc surfaces **34** of first arm **31** and second arm **32** abut on the surface **20** of the capacitor **4** in a form and force fitting manner,

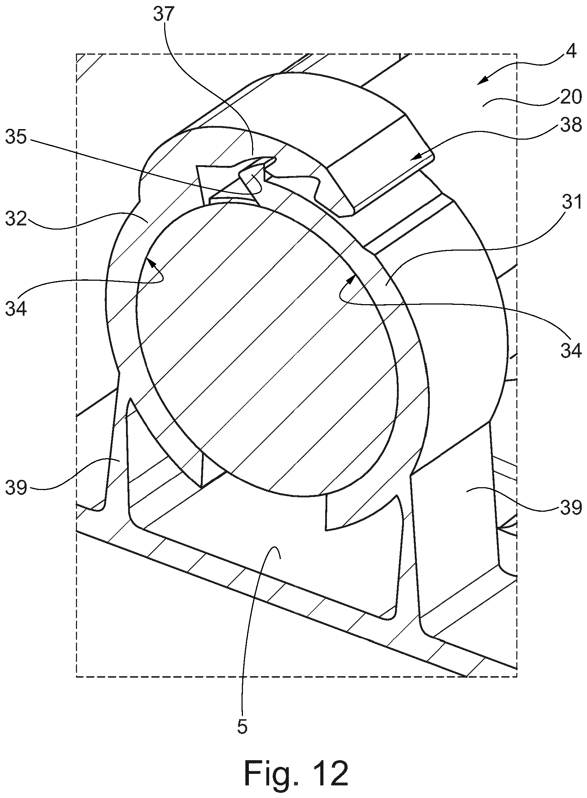

**Figure 12** is a perspective front view of the mounting structure **3** (cradle) as shown in Fig. 8, with a capacitor **4** fixed in place, wherein capacitor **4** has the minimum allowed diameter **4D.** Nose **35** of first arm **31** is inserted into another recess **37** of second arm **32** which other recess **37** is further away from the free end **38** of second arm **32.** This formation allows that even with the minimum allowed diameter **4D** of capacitor **4,** the inner circular arc surfaces **34** of the first arm **31** and the second arm **32** abut on the surface **20** of capacitor **4** in a form and force fitting manner.

It is believed that the present disclosure and many of its attendant advantages will be understood by the foregoing description, and it will be apparent that various changes may be made in the form, construction, number and arrangement of the components without departing from the disclosed subject matter or without sacrificing all of its material advantages. The form described is merely explanatory, and it is the intention of the following claims to encompass and include such changes. Accordingly, the scope of the invention should be limited only by the claims appended hereto.

### LIST OF REFERENCE NUMERALS

- 1: Electronic control unit (ECU)
- 2: Housing
- 3: Mounting structure, cradle
- 4: Capacitor
- 4D: Capacitor diameter
- 5: Bottom
- 6: Support surface
- 7: Alignment support
- 8: Circumferential notch
- 9: Housing part
- 11: First pair
- 12: Second pair
- 13: Holding element
- 14: Free end
- 15: Nose
- 15D: Distance
- 16: Vehicle
- 18: Vehicle battery
- 19: Electric line
- 20: Surface
- 22: Area
- 24: Gap
- 31: First arm
- 32: Second arm
- 34: Inner circular arc surface
- 35: Nose
- 36: Free end
- 37: Recess
- 38: Free end
- 39: Elastic leg
- A1: holding element
- A2: holding element
- B1: holding element
- B2: holding element
- Y: Y-direction
- Z: Z-direction

## Claims

1. A mounting structure (3) for a capacitor (4), comprising
a first pair (11) and a second pair (12) of holding elements (13), which are integral parts of the mounting structure (3),
**characterized in that**
the second pair (12) of holding elements (13) is defined by a first arm (31) and a second arm (32), each having an inner circular arc surface (34) with a curvature being the same as the curvature of a surface (20) of the capacitor (4);
a nose (35) is formed at a free end (36) of the first arm (31); and
at least two recesses (37) are formed at a free end (38) of the second arm (32) at different distances from the free end (38), wherein the inner circular arc surface (34) of the first arm (31) and the second arm (32) abut on the surface (20) of the capacitor (4) when the nose (35) cooperates with one of the at least two recesses (37), the respective recess (37) selected based on the diameter of the capacitor (4).

2. The mounting structure (3) according to claim 1, wherein the mounting structure (3) is injection-molded, and each of the first arm (31) and the second arm (32) of the second pair (12) of holding elements (13) is connected via a leg (39) to a bottom (5) of the mounting structure (3).

3. The mounting structure (3) according to claim 2, wherein the first arm (31) and the second arm (32) of the second pair (12) of holding elements (13) are molded such that the first arm (31) and the second arm (32) form an open position which allows insertion of the capacitor (4).

4. The mounting structure (3) according to any one of the preceding claims, wherein the nose (35) of the first arm (31) is inserted in the recess (37) close to the free end (38) of the second arm (32), and the inner circular arc surfaces (34) of the first arm (31) and the second arm (32) abut on the surface (20) of the capacitor (4) in a form and force fitting manner, wherein the capacitor (4) has a diameter (4D) of the maximum allowable tolerance.

5. The mounting structure (3) according to any one of the preceding claims 1 to 3, wherein the nose (35) of the first arm (31) is inserted into the recess (37) further away from the free end (38) of the second arm (32), and the inner circular arc surfaces (34) of the first arm (31) and the second arm (32) abut on the surface (20) of the capacitor (4) in a form and force fitting manner, wherein the capacitor (4) has a diameter (4D) of the minimum allowable tolerance.

6. The mounting structure (3) according to any one of the preceding claims, wherein a housing part (9) and the mounting structure (3) are injection-molded so that the mounting structure (3) is an integral part of the housing part (9).

7. Use of a mounting structure (3) as claimed in any one of the preceding claims in an electronic control unit (1) for a vehicle (16).

## Patentansprüche

1. Eine Montagestruktur (3) für einen Kondensator (4), umfassend
ein erstes Paar (11) und ein zweites Paar (12) von Halteelementen (13), die integrale Bestandteile der Montagestruktur (3) sind,
**dadurch gekennzeichnet, dass**
das zweite Paar (12) von Halteelementen (13) durch einen ersten Arm (31) und einen zweiten Arm (32) definiert ist, die jeweils eine innere Kreisbogenfläche (34) mit einer Krümmung aufweisen, die der Krümmung von einer Oberfläche (20) des Kondensators (4) entspricht;
eine Nase (35) an einem freien Ende (36) des ersten Arms (31) ausgebildet ist; und
mindestens zwei Ausnehmungen (37) an einem freien Ende (38) des zweiten Arms (32) in unterschiedlichen Abständen von dem freien Ende (38) ausgebildet sind, wobei die innere Kreisbogenfläche (34) des ersten Arms (31) und des zweiten Arms (32) an der Oberfläche (20) des Kondensators (4) anliegt, wenn die Nase (35) mit einer der mindestens zwei Ausnehmungen (37) zusammenwirkt, wobei die jeweilige Ausnehmung (37) in Abhängigkeit von dem Durchmesser des Kondensators (4) ausgewählt ist.

2. Die Montagestruktur (3) nach Anspruch 1, wobei die Montagestruktur (3) spritzgegossen ist und der erste Arm (31) und der zweite Arm (32) des zweiten Paares (12) von Halteelementen (13) jeweils über einen Schenkel (39) mit einem Boden (5) der Montagestruktur (3) verbunden ist.

3. Die Montagestruktur (3) nach Anspruch 2, wobei der erste Arm (31) und der zweite Arm (32) des zweiten Paares (12) von Halteelementen (13) so geformt sind, dass der erste Arm (31) und der zweite Arm (32) eine offene Position bilden, die das Einsetzen des Kondensators (4) ermöglicht.

4. Die Montagestruktur (3) nach einem der vorhergehenden Ansprüche, wobei die Nase (35) des ersten Arms (31) in die Ausnehmung (37) nahe dem freien Ende (38) des zweiten Arms (32) eingesetzt ist und die inneren Kreisbogenflächen (34) des ersten Arms (31) und des zweiten Arms (32) form- und kraftschlüssig an der Oberfläche (20) des Kondensators (4) anliegen, wobei der Kondensator (4) einen Durchmesser (4D) der maximal zulässigen Toleranz aufweist.

5. Die Montagestruktur (3) nach einem der vorhergehenden Ansprüche 1 bis 3, wobei die Nase (35) des ersten Arms (31) weiter entfernt vom freien Ende (38) des zweiten Arms (32) in die Ausnehmung (37) eingesetzt ist, und die inneren Kreisbogenflächen (34) des ersten Arms (31) und des zweiten Arms (32) form- und kraftschlüssig an der Oberfläche (20) des Kondensators (4) anliegen, wobei der Kondensator (4) einen Durchmesser (4D) der minimal zulässigen Toleranz aufweist.

6. Die Montagestruktur (3) nach einem der vorhergehenden Ansprüche, wobei ein Gehäuseteil (9) und die Montagestruktur (3) spritzgegossen sind, so dass die Montagestruktur (3) ein integraler Bestandteil des Gehäuseteils (9) ist.

7. Verwendung einer Montagestruktur (3) nach einem der vorhergehenden Ansprüche in einer elektronischen Steuervorrichtung (1) für ein Fahrzeug (16).

## Revendications

1. Une structure de montage (3) pour un condensateur (4), comprenant
une première paire (11) et une deuxième paire (12) d'éléments de maintien (13), qui font partie intégrante de la structure de montage (3),
**caractérisée en ce que**
la deuxième paire (12) d'éléments de maintien (13) est définie par un premier bras (31) et un deuxième bras (32), chacun ayant une surface d'arc circulaire intérieur (34) dont la courbure est identique à celle d'une surface (20) du condensateur (4) ;
un nez (35) est formé à une extrémité libre (36) du premier bras (31) ; et au moins deux renfoncements (37) sont formés à une extrémité libre (38) du deuxième bras (32) à des distances différentes de l'extrémité libre (38), dans lequel la surface d'arc circulaire intérieur (34) du premier bras (31) et du deuxième bras (32) bute contre la surface (20) du condensateur (4) lorsque le nez (35) coopère avec l'un des au moins deux renfoncements (37), le renfoncement respectif (37) étant sélectionné en fonction du diamètre du condensateur (4).

2. La structure de montage (3) selon la revendication 1, dans laquelle la structure de montage (3) est moulée par injection, et chacun des premier bras (31) et deuxième bras (32) de la deuxième paire (12) d'éléments de maintien (13) est relié par l'intermédiaire d'une jambe (39) à un fond (5) de la structure de montage (3).

3. La structure de montage (3) selon la revendication 2, dans laquelle le premier bras (31) et le deuxième bras (32) de la deuxième paire (12) d'éléments de maintien (13) sont moulés de telle sorte que le premier bras (31) et le deuxième bras (32) forment une position ouverte qui permet l'insertion du condensateur (4).

4. La structure de montage (3) selon l'une quelconque des revendications précédentes, dans laquelle le nez (35) du premier bras (31) est inséré dans le renfoncement (37) à proximité de l'extrémité libre (38) du deuxième bras (32), et les surfaces d'arc circulaire intérieures (34) du premier bras (31) et du deuxième bras (32) butent contre la surface (20) du condensateur (4) de manière à s'ajuster par forme et par force, dans laquelle le condensateur (4) a un diamètre (4D) correspondant à la tolérance maximale admissible.

5. La structure de montage (3) selon l'une quelconque des revendications 1 à 3 précédentes, dans laquelle le nez (35) du premier bras (31) est inséré dans le renfoncement (37) plus loin de l'extrémité libre (38) du deuxième bras (32), et les surfaces d'arc circulaire intérieures (34) du premier bras (31) et du deuxième bras (32) butent contre la surface (20) du condensateur (4) de manière à s'ajuster par forme et par force, dans laquelle le condensateur (4) a un diamètre (4D) correspondant à la tolérance minimale admissible.

6. La structure de montage (3) selon l'une quelconque des revendications précédentes, dans laquelle une partie de boîtier (9) et la structure de montage (3) sont moulées par injection de telle sorte que la structure de montage (3) fait partie intégrante de la partie de boîtier (9).

7. Utilisation d'une structure de montage (3) selon l'une quelconque des revendications précédentes dans une unité de commande électronique (1) pour un véhicule (16).
